# EUROPEAN PATENT SPECIFICATION

(11) **EP 2 372 226 B1**
(45) Date of publication and mention of the grant of the patent: **10.09.2014**
(21) Application number: 10197087.9
(22) Date of filing: 27.12.2010
(51) Int. Cl.: F21V 13/04, F21V 14/02, F21V 19/02, F21Y 101/02, F21V 3/04, F21V 5/04, F21V 7/04, F21V 7/22, F21W 131/406

(54) **LED light projector with single reflected beam**
LED-Scheinwerfer mit einem einzelnen reflektierten Strahl
Projecteur à DEL avec un seul faisceau réflecté

(30) Priority: 23.03.2010 IT PR20100021
(43) Date of publication of application: 05.10.2011
(73) Proprietor: COEMAR S.p.A., 46042 Castel Goffredo (MN) (IT)
(72) Inventor: Allegri, Fabio, 46042, CASTEL GOFFREDO (MN) (IT)
(74) Representative: Perronace, Andrea

(56) References cited:
- WO-A1-2008/050783
- WO-A1-2009/101553
- JP-A- 2005 100 723
- US-A1- 2009 103 293

## Description

The present invention relates to a LED light projector, in particular for use in the sector of show business.

As is known, the market already offers various types of projectors using LED light sources. One of the most common solutions includes electronic mixing (using software programs) of light beams emanating from a plurality of white LED sources, or LED sources of other colours mounted on a support.

The main disadvantage of this solution is that even if the mixing is a good and accurate one, when frontally observing the projector the observer perceives a collection of points of different colours, each corresponding to one of the sources forming the projector. In practice, the illumination becomes homogeneous only at a certain distance from the projector, but there is a not-insignificant tract in which the different coloured light beams giving rise to the final mixed beam are distinguishable.

There also exists the possibility of obtaining a better homogenisation by predisposing small groups of LED sources under a single lens or a single optical element (see patent application PR2008A000029 filed by the same applicant). However, it is not possible to predispose all the LED sources of a large-dimension projector under a single optical element. Therefore, in this case too, there remains the problem of dishomogeneity in the beam when viewed frontally.

Among other things, many of these solutions, in order to reach high levels of power, must be excessively large.

A further disadvantage of the known solutions lies in the fact that in order to modify the aperture of the mixed cone rather complex optics are required, which however do not solve the problem of the frontal perception of a plurality of beams.

D1 discloses a light emitting device using one or more light emitting diodes within a light mixing cavity. The light emitting device includes a light adjustment member that is movable to alter the shape or colour of the light produced.

In this context, the technical task at the basis of the present invention is to provide a LED light projector which obviates the drawbacks in the prior art.

In particular, an aim of the present invention is to make available a LED light projector able to uniformly mix the light beams emitted by the single LED sources, such that an observer located frontally of the projector perceives a homogeneous illumination.

A further aim of the present invention is to provide a LED light projector in which the aperture of the light cone emitted is easily modifiable.

A further aim of the present invention is to provide a LED light projector having smaller dimensions with respect to the solutions in the prior art.

The defined technical task and the set aims are substantially attained by a LED light projector, comprising the technical characteristics set out in one or more of the appended claims.

Further characteristics and advantages of the present invention will emerge more clearly from the indicative and therefore non-limiting description, of a preferred but not exclusive embodiment of a LED light projector, as illustrated in the accompanying drawings, in which:
- figures 1 illustrates a LED light projector, according to the present invention, in a first embodiment, in a lateral section view;
- figure 2 illustrates the projector of figure 1, in a second embodiment, in a lateral section view;
- figure 3 and 4 illustrate a a further embodiment of the projector of figure 1 or 2, in a simplified schematic view.

With reference to the figures, 1 denotes a LED light projector, in particular to be used in the show business sector. The projector 1 comprises a plurality of LED light sources 3, capable of emitting a corresponding number of light beams 4. The projector 1 is further provided with means 17 for mixing the light beams 4 originating from the sources 3 in such a way as to obtain a single beam 14. The means 17 comprise an optical element 8 located opposite the light sources 3. Preferably, the optical element 8 is a frosted optical lens. In particular, the frosted optical lens 8 is obtained from an assembly of optical micro-lenses. Originally, the projector 1 comprises a box-like body 7 internally housing the light sources 3. The box-like body 7 advantageously has interior walls 7a that are white-painted, which form part of the means 17 for mixing the light beams 4 issued by the sources 3. The interior walls 7a are preferably coated with compounds based on calcium carbonate or magnesium carbonate in order to achieve a high diffusion power. Alternatively, the interior walls 7a are coated with titanium-based compounds.

In a preferred embodiment, a reflecting surface 2 is set at a pre-established distance d from the optical lens 8 so that said single beam 14 strikes the reflecting surface 2, giving rise by reflection to a homogeneous light cone 6. The reflecting surface 2 is preferably parabolic or spherical. The pre-established distance d is variable so as to modify the aperture of the light cone 6.

Alternatively, the light coming from said single beam 14 may be used.

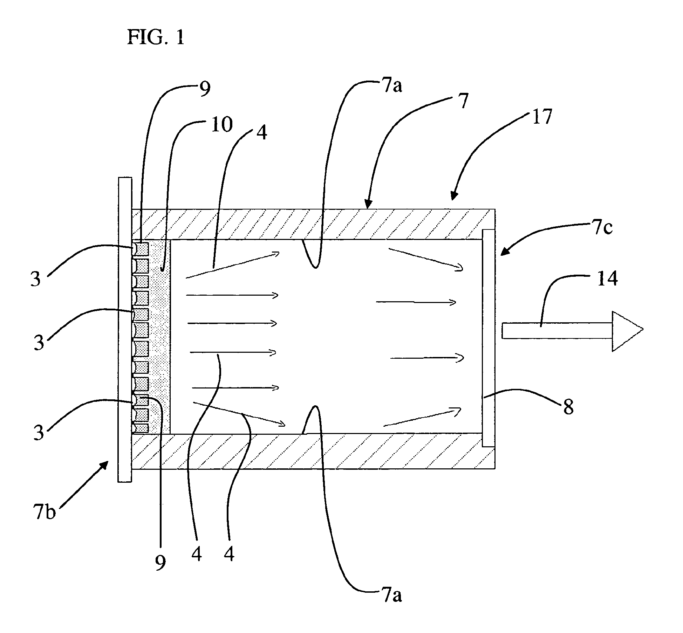

In a first embodiment, illustrated in figure 1, the box-like body 7 substantially has the shape of a cylinder. The LED light sources 3 are housed at a first base 7b of the cylinder 7. The optical element 8 is located at a second base 7c of the cylinder 7, placed opposite the reflecting surface 2. In the case of the cylindrical body 7, the interior walls 7a coincide with the interior lateral surface of the cylinder 7.

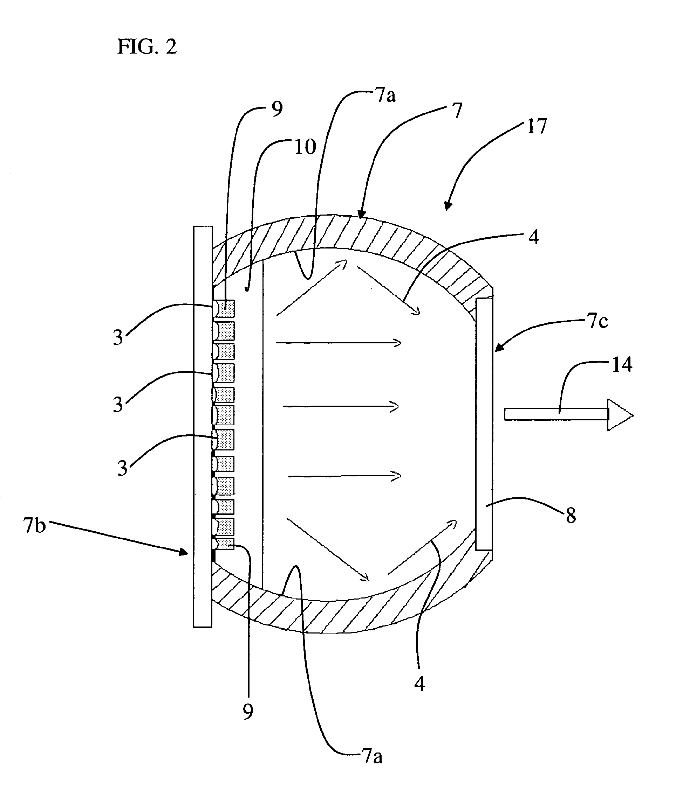

In a second embodiment, illustrated in figure 2, the box-like body 7 has outwardly-rounded interior walls 7a so as to favour the convergence of the light beams 4 issued by the sources 3 toward the optical element 8.

In the terminology used in the present description, by pre-established distance d is meant the distance of the optical element 8 from the centre of curvature of the parabolic or spherical reflecting surface 2.

The light sources 3 are regularly disposed on the first base 7b in such a way as to form a circular light support having a diameter which is smaller than or equal to the height of the box-like body 7.

A layer 10 of resin is arranged such as to cover the sources 3.

In the embodiments described and illustrated herein, the projector 1 comprises a plurality of lenses 9, each of which is operatively active upon a corresponding LED light source 3 so as to condition the emitted light beam 4.

Both the light sources 3 and the lenses 9 are preferably immersed in a layer 10 of resin.

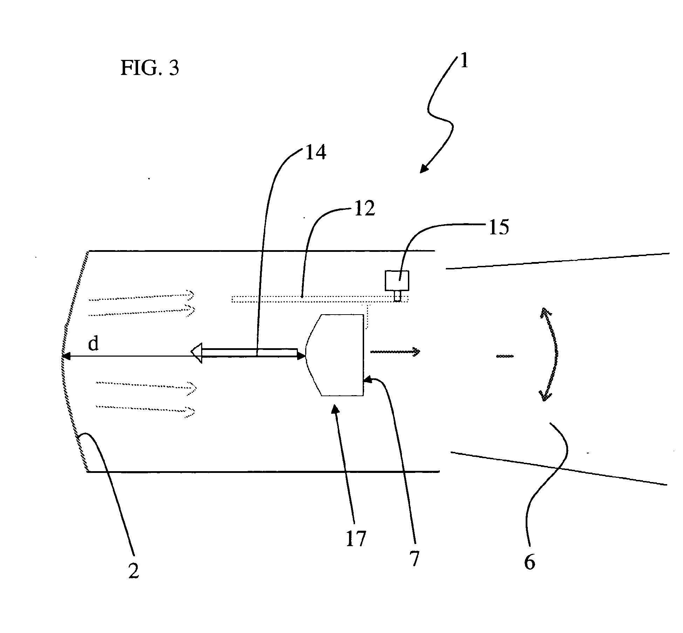

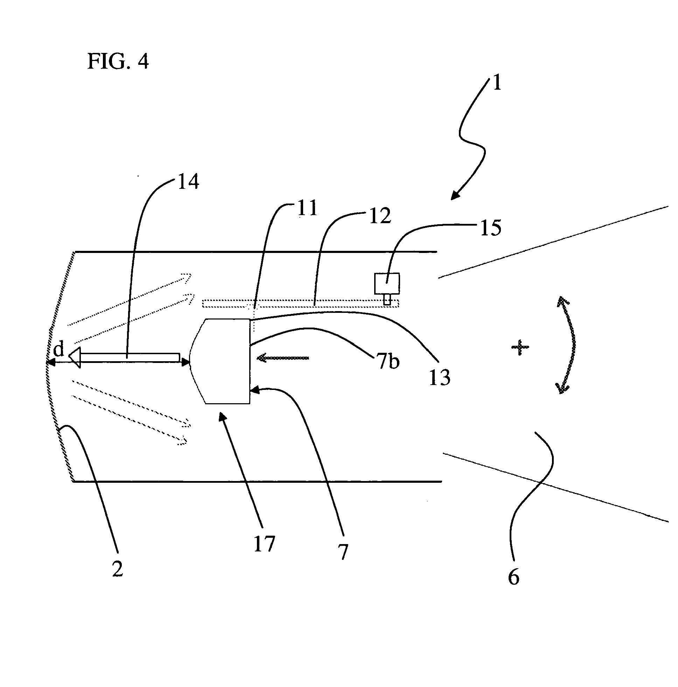

The box-like body 7 is preferably provided with a slide 11 designed to slide on a guide 12 extending substantially parallel to the main optical axis of the reflecting surface 2. In particular, the slide 11 and the guide 12 constitute means for varying the pred-established distance d. For example, as illustrated in figures 3 and 4, the box-like body 7 is provided with a support 13, positioned at a first base 7b thereof, on which the slide 11 slidable on the guide 12 is fashioned. The sliding of the slide 11 on the guide 12 can be performed manually or by means of motorised activation. Figures 3 and 4 schematically illustrate a motor 15 for activating the sliding of the slide 11 along the guide 12.

The functioning of the LED light projector is described in the following.

The LED light sources 3 emit light beams 4 which are reflected by the white-painted interior walls 7a of the box-like body 7 such as to become mixed. In particular, the mixing of the light beams 4 emitted by sources 3 is completed by the passage thereof through the lenses 9, the layer 10 of resin and the frosted lens 8. A single beam 14 thus exits from the box-like body 7.

In the illustrated embodiment, said single beam 14 strikes on the reflecting surface 2, is reflected in a plurality of directions and generates the homogeneous light cone 6. To broaden the opening of the light cone 6, the box-like body 7 is moved by sliding the slide 11 on the guide 12 in a nearing direction to the reflecting surface 2. On the contrary, to narrow the aperture of the light cone 6, the box-like body 7 is moved by sliding the slide 11 on the guide 12 in a distancing direction from the reflecting surface 2.

From the above description the characteristics of the LED light projector of the invention emerge clearly, as do the advantages.

In particular, thanks to the use of the box-like body having white-painted internal walls based on calcium carbonate or magnesium carbonate or titanium, which have a high diffusive capacity, an optimal mixture of the light beams emitted by the sources can be obtained.

In addition, thanks to the use of the reflecting surface, the light emitted by the LED light sources can be indirectly exploited, thus achieving a uniform mixing of the mixed light beam originating from the box-like body. An observer located frontally of the projector cannot establish the type of the light source, but perceives a homogeneous illumination. In particular, the light sources are not visible to the observer.

The mixing of the beams is particularly appreciated in the theatre sector, as when projecting a shape on a background flat (at the cone side) a profile of the shadow is obtained that has a defined perimeter, which obviates the problems associated with multiplication of the shadows obtained with a traditional-type projection. The structure of the box-like body contributes significantly to the uniformity of the mix, in which the box-like body, the lenses, the layer of resin and the frosted lens complete the mixing which has already been performed by the white-painted internal walls. For example, the cylindrical realisation enables less light dispersion to be obtained, while the realisation with outwardly-rounded walls enables the mixing to be further optimised.

Further, the aperture of the light cone generated by the projector is modifiable simply by moving the cylindrical body housing the light sources either towards or away from the reflecting surface.

Finally, the realising of a compact box-like body, destined to mix the various beams such as to obtain a single beam in outlet, enables the dimensions of the box-like body to be notably reduced with respect to the prior-art projectors.

## Claims

1. A LED light projector (1), comprising:
a plurality of LED light sources (3) capable of emitting a corresponding number of light beams (4);
means (17) for mixing the light beams (4) originating from the LED light sources (3) in such a way as to obtain a single beam (14), said means (17) comprising an optical element (8) located opposite said light sources (3) said optical element (8) being a frosted optical lens;
a box-like body (7) housing within it said light sources (3), said box-like body (7) having interior walls (7a) painted white which form part of the means (17) for mixing the light beams (4) issued by the sources (3);
at least one reflecting surface (2) set at a pre-established distance (d) from said optical element (8) so that said single beam (14) strikes the reflecting surface (2), giving rise by reflection to a homogeneous light cone (6), said pre-established distance (d) being variable so as to modify the aperture of said light cone (6),
**characterised in that** said box-like body (7) is provided with a slide (11) designed to slide on a guide (12) extending substantially parallel to the main optical axis of said reflecting surface (2), said slide (11) and said guide (12) forming means for varying said pre-established distance (d).

2. Projector according to claim 1, wherein said interior walls (7a) are coated with compounds based on calcium carbonate or magnesium carbonate in order to achieve a high diffusion power.

3. Projector (1) according to claim 1, wherein said interior walls (7a) are coated with compounds based on titanium in order to achieve a high diffusion power.

4. Projector (1) according to any of the preceding claims, wherein said box-like body (7) substantially the shape of a cylinder having a first base (7b), where said LED light sources (3) are housed, and a second base (7c), where said optical element (8) is disposed, said interior walls (7a) coinciding with the interior lateral surface of said cylinder (7).

5. Projector (1) according to claims 1 to 3, wherein said box-like body (7) has:
a first base (7b), where said LED light sources (3) are housed;
a second base (7c), where said optical element (8) is disposed;
interior walls (7a) that are outwardly rounded so as to favour the convergence of the light beams (4) issued by the sources (3) toward the optical element (8).

6. Projector (1) according to claim 4 or 5, wherein the light sources (3) are regularly disposed on said first base (7b) in such a way as to form a circular light support having a diameter smaller than or equal to the height of said box-like body (7).

7. Projector (1) according to any one of the preceding claims, further comprising a layer (10) of resin applied as covering for said LED light sources (3).

8. Projector (1) according to any one of claims from 1 to 6, further comprising a plurality of lenses (9), each of which is operatively active upon the corresponding LED light source (3) so as to condition the emitted light beam (4).

9. Projector according to any of the preceding claims, further comprising a layer (10) of resin applied as covering for the LED light sources (3), said lenses (9) being immersed in the layer (10) of resin.

10. Projector (1) according to claim 1, wherein said reflecting surface (2) is parabolic or spherical.

11. Projector according to any of the preceding claims, wherein the frosted optical lens is obtained from an assembly of optical micro-lenses.

## Patentansprüche

1. Ein LED-Scheinwerfer (1), umfassend:
eine Vielzahl von LED-Lichtquellen (3), die in der Lage sind, eine entsprechende Anzahl von Lichtstrahlen (4) auszusenden;
Mittel (17) zur Mischung der von den LED-Lichtquellen (3) erzeugten Lichtstrahlen (4), um einen einzelnen Strahl (14) zu erhalten, wobei die Mittel (17) ein optisches Element (8) aufweisen, das gegenüberliegend zu den Lichtquellen (3) angeordnet ist, wobei das optische Element (8) eine mattierte optische Linse ist;
ein boxenförmiger Körper (7), der die Lichtquellen (3) umhaust, wobei der boxenförmige Körper (7) weiß angestrichene Innenwände (7a) hat, die einen Teil des Mittels (17) zur Mischung der von den Quellen (3) erzeugten Lichtstrahlen (4) bilden;
zumindest eine reflektierende Oberfläche (2), die in einem vorab festgelegten Abstand (d) von dem optischen Element (8) vorgesehen ist, so dass der einzelne Strahl (14) die reflektierende Oberfläche (2) trifft und durch Reflektion einen homogenen Lichtkegel (6) bildet, wobei der vorab festgelegte Abstand(d) variabel ist, um die Öffnung des Lichtkegels (6) zu verändern;
**dadurch gekennzeichnet, dass** der boxenförmige Körper (7) mit einem Schieber (11) versehen ist, der ausgeführt ist, um auf einer Führung (12), die sich im Wesentlichen parallel zu der optischen Hauptachse der reflektierenden Oberfläche (2) erstreckt, zu gleiten, wobei der Schieber (11) und die Führung (12) Mittel ausbilden, um den vorher festgelegten Abstand (d) zu variieren.

2. Projektor nach Anspruch 1, wobei die Innenwände (7a) mit einer Verbindung basierend auf Calciumcarbonat oder Magnesiumcarbonat beschichtet sind, um eine hohe Streuwirkung zu erzielen.

3. Projektor (1) nach Anspruch 1, wobei die Innenwände (7a) mit einer Verbindung basierend auf Titanium beschichtet sind, um eine hohe Streuwirkung zu erzielen.

4. Projektor (1) nach einem der vorhergehenden Ansprüche, wobei der boxenförmige Körper (7) im Wesentlichen die Form eines Zylinders mit einem ersten Boden (7b), wo die LED-Lichtquellen (3) untergebracht sind, und einen zweiten Boden (7c), wo das optische Element (8) angeordnet ist, aufweist, wobei die Innenwände (7a) mit der inneren seitlichen Fläche des Zylinders (7) zusammenfallen.

5. Projektor (1) nach den Ansprüchen 1 bis 3, wobei der boxenförmige Körper (7) aufweist:
einen ersten Boden (7b), wo die LED-Lichtquellen (3) untergebracht sind;
einen zweiten Boden (7c), wo das optische Element (8) vorgesehen ist;
Innenwände (7a), die nach außen hin gekrümmt sind, um so die Konvergenz der von den Quellen (3) erzeugten Lichtstrahlen (4) hin zu dem optischen Element (8) zu begünstigen.

6. Projektor (1) nach den Ansprüchen 4 oder 5, wobei die Lichtquellen (3) regelmäßig auf dem ersten Boden (7b) angeordnet sind, derart, dass sie einen kreisförmigen Lichtträger mit einem Durchmesser, der kleiner oder gleich groß wie die Höhe des boxenförmigen Körpers (7) ist, bilden.

7. Projektor (1) nach einem der vorhergehenden Ansprüche, ferner umfassend eine Harzschicht (10), die als Abdeckung für die LED-Lichtquellen (3) aufgebracht ist.

8. Projektor (1) nach einem der Ansprüche 1 bis 6, ferner umfassend eine Vielzahl von Linsen (9), von denen jede operativ auf die entsprechenden Lichtquellen (3) aktiv ist, um den ausgesendeten Lichtstrahl (4) zu konditionieren.

9. Projektor nach einem der vorhergehenden Ansprüche, ferner umfassend eine Harzschicht (10), die als Abdeckung für die LED-Lichtquellen (3) aufgebracht ist, wobei die Linsen (9) in die Harzschicht (10) eingetaucht sind.

10. Projektor (1) nach Anspruch 1, wobei die reflektierende Oberfläche (2) parabolisch oder sphärisch ist.

11. Projektor nach einem der vorhergehenden Ansprüche, wobei die mattierte optische Linse durch eine Anordnung optischer Mikrolinsen erhalten wird.

## Revendications

1. Projecteur à DEL (1), comprenant:
une pluralité de sources lumineuses à DEL (3) capables d'émettre un nombre correspondant de faisceaux lumineux (4) ;
des moyens (17) de mélange des faisceaux lumineux (4) émis par les sources lumineuses à DEL (3) de façon à obtenir un faisceau unique (14), lesdits moyens (17) comprenant un élément optique (8) situé en face desdites sources lumineuses (3), ledit élément optique (8) étant une lentille optique dépolie ;
un corps de type caisson (7) à l'intérieur duquel sont logées lesdites sources lumineuses (3), ledit corps de type caisson (7) étant pourvu de parois internes (7a) peintes en blanc, lesquelles font partie des moyens (17) de mélange des faisceaux lumineux (4) émis par les sources (3) ;
au moins une surface réfléchissante (2) située à une distance préétablie (d) dudit élément optique (8) de sorte que ledit faisceau unique (14) frappe la surface réfléchissante (2), créant par réflexion un cône lumineux (6) homogène, ladite distance (d) préétablie étant variable de façon à modifier l'ouverture dudit cône lumineux (6),
**caractérisé en ce que** le corps de type caisson (7) est pourvu d'une coulisse (11) conçue pour coulisser sur un guide (12) s'étendant de manière sensiblement parallèle à l'axe optique principal de ladite surface réfléchissante (2), ladite coulisse (11) et ledit guide (12) formant des moyens destinés à faire varier ladite distance préétablie (d).

2. Projecteur selon la revendication 1, dans lequel lesdites parois intérieures (7a) sont revêtues de composés à base de carbonate de calcium ou de carbonate de magnésium afin d'obtenir une puissance de diffusion élevée.

3. Projecteur (1) selon la revendication 1, dans lequel lesdites parois intérieures (7a) sont revêtues de composés à base de titane afin d'obtenir une puissance de diffusion élevée.

4. Projecteur (1) selon l'une quelconque des revendications précédentes, dans lequel ledit corps de type caisson (7) a sensiblement la forme d'un cylindre ayant une première base (7b) où sont logées lesdites sources lumineuses à DEL (3) et une seconde base (7c) où est disposé ledit élément optique (8), lesdites parois intérieures (7a) coïncidant avec la surface latérale intérieure dudit cylindre (7).

5. Projecteur (1) selon les revendications 1 à 3, dans lequel ledit corps de type caisson (7) présente :
une première base (7b) où sont logées lesdites sources lumineuses à DEL (3) ;
une seconde base (7c) où est disposé ledit élément optique (8) ;
des parois intérieures (7a) arrondies extérieurement afin de favoriser la convergence des faisceaux lumineux (4) émis par les sources (3) vers l'élément optique (8).

6. Projecteur (1) selon la revendication 4 ou 5, dans lequel les sources lumineuses (3) sont régulièrement disposées sur ladite première base (7b) de façon à former un support lumineux circulaire dont le diamètre est inférieur ou égal à la hauteur dudit corps de type caisson (7).

7. Projecteur (1) selon l'une quelconque des revendications précédentes, comprenant, en outre, une couche (10) de résine appliquée de façon à recouvrir lesdites sources lumineuses à DEL (3).

8. Projecteur (1) selon l'une quelconque des revendications 1 à 6, comprenant, en outre, une pluralité de lentilles (9), chacune agissant fonctionnellement sur la source lumineuse à DEL (3) correspondante de façon à conditionner le faisceau lumineux (4) émis.

9. Projecteur selon l'une quelconque des revendications précédentes, comprenant, en outre, une couche (10) de résine appliquée de façon à recouvrir les sources lumineuses à DEL (3), lesdites lentilles (9) étant noyées dans la couche (10) de résine.

10. Projecteur selon la revendication 1, dans lequel ladite surface réfléchissante (2) est parabolique ou sphérique.

11. Projecteur selon l'une quelconque des revendications précédentes, dans lequel la lentille optique dépolie est obtenue à partir d'un ensemble de micro-lentilles optiques.
